# EUROPÄISCHE PATENTSCHRIFT

(11) **EP 1 085 588 B1**
(45) Veröffentlichungstag und Bekanntmachung des Hinweises auf die Patenterteilung: **24.08.2005**
(21) Anmeldenummer: 00113441.0
(22) Anmeldetag: 24.06.2000
(51) Int. Cl.: H01M 2/10

(54) **Gehäuse mit einem Fach zur Aufnahme von Batterien für ein tragbares elektrisches Gerät**
Housing comprising a battery compartment for a portable electric device
Boîtier comprenant un compartiment pour piles pour un appareil électrique portatif

(30) Priorität: 18.09.1999 DE 29916458 U
(43) Veröffentlichungstag der Anmeldung: 21.03.2001
(73) Patentinhaber: Sennheiser electronic GmbH & Co. KG, 30900 Wedemark (DE)
(72) Erfinder: Donauer, Herbert, 30900 Wedemark (DE); Erdmann, Wilhelm, 30900 Wedemark (DE)
(74) Vertreter: Eisenführ, Speiser & Partner

(56) Entgegenhaltungen:
- US-A- 4 431 717
- US-A- 5 384 207
- US-A- 5 780 992
- US-A- 5 980 310
- PATENT ABSTRACTS OF JAPAN vol. 018, no. 629 (E-1637), 30. November 1994 (1994-11-30) -& JP 06 244743 A (MATSUSHITA SEIKO CO LTD), 2. September 1994 (1994-09-02)
- PATENT ABSTRACTS OF JAPAN vol. 1995, no. 04, 31. Mai 1995 (1995-05-31) -& JP 07 022010 A (CASIO COMPUT CO LTD), 24. Januar 1995 (1995-01-24)

## Beschreibung

Die Erfindung betrifft ein Gehäuse für ein tragbares elektrisches Gerät zur Übertragung von Signalen, insbesondere von Tonsignalen, mit einem Fach zur Aufnahme von Batterien und/oder Akkumulatoren für eine Spannungsversorgung des Gerätes und von Anschlüssen zum Anschluß der Batterien an das Gerät, einem Bereich für Bedienorgane zum Bedienen des Gerätes und wenigstens einem Frontplattenbereich zur Aufnahme einer Frontplatte zum Ablesen von Einstellungen der Bedienorgane.

Gehäuse der vorstehenden Art sind als Gehäuse eines tragbaren elektrischen Geräts z.B. eines drahtlosen Mikrofon-Senders bekannt. Sie dienen der Aufnahme einer elektrischen Schaltung des Geräts, von Batterien bzw. Akkumulatoren zur Spannungsversorgung der elektrischen Schaltung, und Bedienorganen zum Steuern der elektrischen Schaltung durch den Benutzer.

Bei tragbaren elektrischen Geräten mit dem bekannten Gehäuse ist je nach eingebauter elektrischer Schaltung die Spannungsversorgung der Schaltung durch Batterien eines bestimmten Typs vorgesehen. Das Batteriefach zur Aufnahme dieser Batterien ist an die Form bzw. Größe ihres Typs angepaßt und für die Aufnahme von entsprechenden Anschlüssen zum Anschluß der Batterien dieses Typs ausgebildet. Bei den bekannten Gehäusen ist ferner der Frontplattenbereich an die aufzunehmende Frontplatte angepaßt, die ihrerseits speziell zum Steuern der Bedienorgane der elektrischen Schaltung ausgebildet ist.

Die bekannten Gehäuse sind nachteilig, weil sie sowohl bezüglich des Batteriefachs als auch bezüglich des Frontplattenbereichs zum Ablesen von Einstellungen der Bedienorgane ausschließlich für einen Einbau und einen Betrieb einer bestimmten elektrischen Schaltung ausgelegt sind. Verschiedene Schaltungen, wie sie beispielsweise bei einer Weiterentwicklung einer ursprünglichen Schaltung entstehen, können zwar u.U. mit verschiedenen Bedienorganen in das bekannte Gehäuse eingesetzt werden, aber der Frontplattenbereich zur Aufnahme der den Bedienorganen entsprechenden Frontplatte sowie das Batteriefach zur Aufnahme der Batterien für eine Spannungsversorgung der jeweiligen elektrischen Schaltung des Gehäuses müssen angepaßt werden. Das Anpassen verursacht in der Entwicklung und Produktion verschiedener Geräte jeweils Kosten, die besonders unerwünscht sind, wenn es sich bei den Geräten um schlichte Weiterentwicklungen desselben Ursprungsgerätes handelt.

In der DE 37 90 276 T1 (WO 87/07435) ist ein Batteriefach offenbart, das zur wahlweisen und abwechselnden Aufnahme einer Lithium-Batterie mit an einer ersten Endfläche angeordneten Plus- und Minuspolen sowie von Alkali-Mangan-Batterien vorgesehen ist, bei denen die Pluspole bzw. Minuspole an einander abgewandten ersten Endflächen bzw. zweiten Endflächen angeordnet sind. Das offenbarte Batteriefach kann demnach wahlweise unterschiedliche Batterietypen mit unterschiedlichen Höhen und unterschiedlicher Anordnung der Plus- und Minuspole aufnehmen. Das Batteriefach weist u.a. Distanzelemente auf, welche wahlweise eine geschlossene Position (wenn eine Batterie in das Batteriefach eingesetzt ist) oder eine offene Position (bei der das Distanzelement in eine vom Batteriefach entfernte Position bewegt ist) einnehmen kann.

Das bekannte Batteriefach ist zwar flexibel, weil es die wahlweise Aufnahme verschiedener Batterietypen erlaubt. Diese Flexibilität ist jedoch nicht auszunutzen, wenn zur Spannungsversorgung des Gerätes mit einer gegebenen elektrischen Schaltung nur ein bestimmter Batterietyp vorgesehen ist. Die beweglichen Distanzelemente des bekannten Batteriefaches sind nachteilig, weil sie zusätzliche Teile sind, die bei der Herstellung eines mit dem Batteriefach versehenen Gehäuses zusätzliche Kosten verursachen und beim Gebrauch des Geräts eine zusätzliche Quelle von Schäden bilden können.

Der Erfindung liegt die Aufgabe zugrunde, ein Gehäuse für ein tragbares, elektrisches Gerät zu schaffen, das besonders kostengünstig herstellbar und einfach zu gebrauchen ist.

Diese Aufgabe wird durch ein Gehäuse für ein tragbares, elektrisches Gerät mit einem Batteriefach gelöst, das für eine alternative Aufnahme von Batterien wenigstens zweier verschiedenen Typen bzw. Größen vorgesehen ist und in dem die Anschlüsse wahlweise zum Anschluß von Batterien der verschiedenen Typen verlegbar sind.

Mit der Erfindung erhält man ein Gehäuse, das sich für verschiedene tragbare, elektrische Geräte eignet. Insbesondere eignet sich das Gehäuse zur Aufnahme der Batterien verschiedenen Typs für die Spannungsversorgung verschiedener elektrischer Schaltungen. Dem in das Batteriefach des erfindungsgemäßen Gehäuses einzusetzenden Batterietyp entsprechend werden bei der Herstellung des jeweiligen Gerätes in dem Batteriefach Anschlüsse verlegt, um die vorgesehene Spannungsversorgung der elektrischen Schaltung des Gerätes zu ermöglichen. Das Gehäuse, bzw. Gehäuseschalen, aus denen das Gehäuse zusammengesetzt ist, sind darum vielseitig für verschiedene Geräte verwendbar.

Bei einer Ausführungsform des Gehäuses ist sein Frontplattenbereich für eine wahlweise Aufnahme verschiedener Frontplatten zum Ablesen von Einstellungen der Bedienorgane vorgesehen. Die den Bedienorganen des jeweiligen elektrischen Gerätes entsprechende Frontplatte wird vorzugsweise bei der Fertigung des Gerätes elektrisch und mechanisch zu einer Einheit mit dem Gehäuse verbunden.

Bei einer anderen Ausführungsform des erfindungsgemäßen Gehäuses ist die Frontplatte an dem Gehäuse lösbar befestigt bzw. von dem Gehäuse lösbar eingefaßt, so daß der Benutzer die Frontplatte austauschen kann, wenn etwa das Gerät um ein Bedienorgan für die elektrische Schaltung erweitert wird.

Das Gerät mit dem erfindungsgemäßen Gehäuse ist beispielsweise ein (Mikrofon-)Taschensender, Taschenempfänger und/oder ein Funkgerät etwa zur Übertragung von Ton- und/oder anderen Signalen mit Hochfrequenzwellen oder Infrarotlicht. Bei derartigen Geräten sind üblicherweise die Innovationszyklen so kurz, daß ständig neue Schaltungen entwickelt werden, für die eine Spannungsversorgung durch verschiedene Batterietypen vorgesehen sein kann und die ggf. verschiedene Bedienorgane zu ihrer Steuerung aufweisen. Das erfindungsgemäße Gehäuse läßt sich universell für eine Vielzahl solcher Geräte verwenden. Die Entwicklungskosten und die Kosten für die Umstellung der Produktion für das tragbare elektrische Gerät sind darum besonders niedrig, wenn die neu entwickelte elektrische Schaltung für eine Aufnahme in dem erfindungsgemäßen Gehäuse vorgesehen ist.

Nachfolgend wird ein Ausführungsbeispiel des erfindungsgemäßen Gehäuses anhand der Figuren näher erläutert. Es zeigen:
- Fig. 1: eine Vorderansicht eines Schnittes durch ein Gerät mit dem erfindungsgemäßen Gehäuse mit darin aufgenommenen Batterien eines ersten Typs;
- Fig. 2: eine Seitenansicht, teilweise im Schnitt, des Gerätes mit den Batterien des ersten Typs;
- Fig. 3: eine Vorderansicht eines Schnittes durch das Gerät mit einer Batterie eines zweiten Typs;
- Fig. 4: eine Seitenansicht, teilweise im Schnitt, des Geräts mit der Batterie des zweiten Typs;
- Fig. 5: eine Vorderansicht, teilweise im Schnitt, des tragbaren elektrischen Geräts;

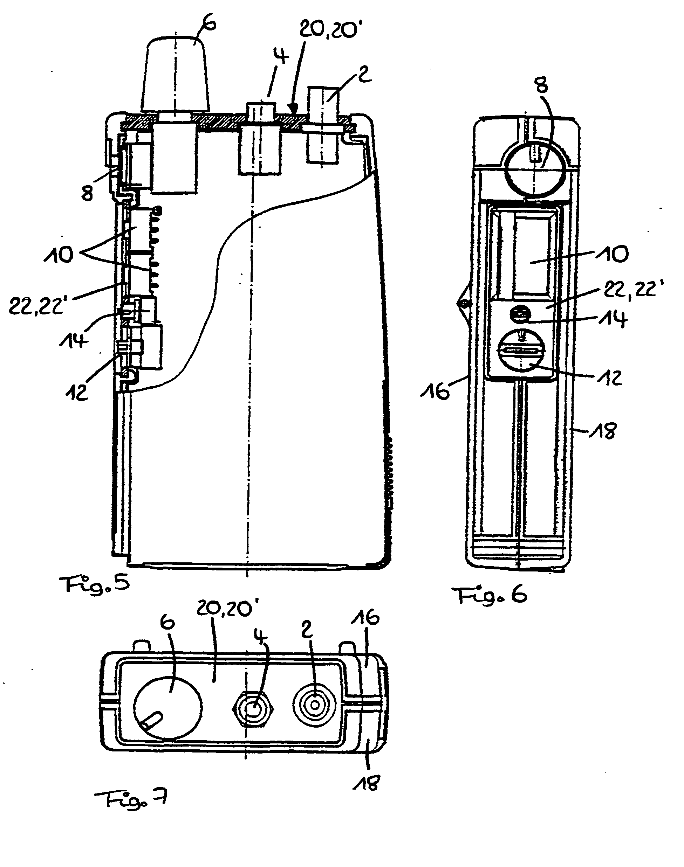

- Fig. 6: eine Seitenansicht des tragbaren elektrischen Geräts; und
- Fig. 7: eine Draufsicht auf das tragbare elektrische Gerät.

Bei dem in den Figuren dargestellten Ausführungsbeispiel handelt es sich um einen tragbaren (Mikrofon-)Taschensender mit dem erfindungsgemäßen Gehäuse. Das Funkgerät beinhaltet eine elektrische Schaltung (nicht dargestellt). Es weist eine Buchse 2 für eine Antenne auf und Bedienorgane, nämlich eine Leuchtanzeige 4 zur Anzeige eines Sendebetriebs, einen Regler 6 zum Regeln der Lautstärke, ein Mikrofon 8, einen Schalter 10 für Empfangs- bzw. Sendebetrieb, einen Drehknopf 12 für eine Frequenzwahl sowie einen Stellknopf 14 für eine Feineinstellung der ausgewählten Frequenz. Die Buchse 2, die Leuchtanzeige 4 sowie der Regler 6 treten durch Auslassungen in einer Frontplatte 20 aus dem Inneren des Gehäuses nach außen. Das Mikrofon 8, der Schalter 10, der Drehknopf 12 und der Stellknopf 14 sind dem Benutzer zur Bedienung an einer Schmalseite zugänglich, indem sie in Auslassungen einer als weitere Frontplatte ausgebildeten Seitenplatte 22 aufgenommen sind. In einem der Frontplatte 20 gegenüberliegenden Bereich des Gehäuses befindet sich ein Batteriefach 24, in dem Batterien 26 bzw. 28 eingesetzt sind.

Das Gehäuse besteht aus einer unteren Gehäuseschale 16 und einer oberen Gehäuseschale 18. Die Gehäuseschalen 16, 18 sind Gußteile, die zur Aufnahme der Frontplatte 20 bzw. der Seitenplatte 22 eine Führung aufweisen. Bei der Fertigung des Funkgerätes werden die Frontplatte 20 mit den darin bereits montierten Bedienorganen 2, 4, 6 sowie die Seitenplatte 22 mit den darin montierten Bedienorganen 8, 10, 12, 14 in die entsprechende Führung der unteren Gehäuseschale 16 eingesetzt. Die obere Gehäuseschale wird auf die untere Gehäuseschale aufgesetzt, wobei die dafür vorgesehene Führung den entsprechenden Bereich der Frontplatte 20 bzw. der Seitenplatte 22 aufnimmt. Die obere Gehäuseschale 18 wird mit der unteren Gehäuseschale 16 mit Schrauben 30 festgeschraubt. Dabei werden die beiden Gehäuseschalen 16, 18 sowie die Frontplatte 20 und die Seitenplatte 22 elektrisch und mechanisch zu einer Gehäuseeinheit verbunden.

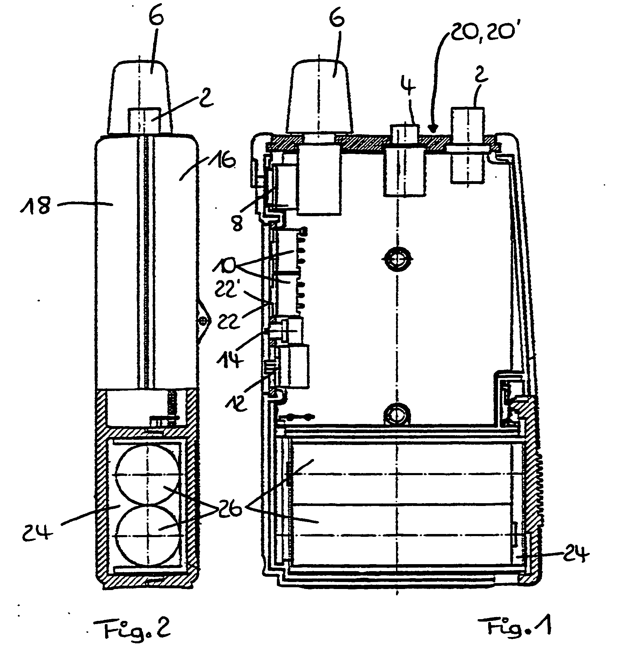

Das in den Figuren 1 und 2 dargestellte Funkgerät ist mit einer ersten elektrischen Schaltung (nicht dargestellt) versehen, die für eine Spannungsversorgung durch zwei Batterien 26 vom Typ "Mignon" vorgesehen ist. Das Batteriefach 24 ist dementsprechend zur Aufnahme der zwei Mignon-Batterien ausgebildet. Es weist Kontaktelemente (nicht dargestellt) auf, um einen Anschluß der Mignon-Batterien 26 an die erste elektrische Schaltung (nicht dargestellt) zu gewährleisten.

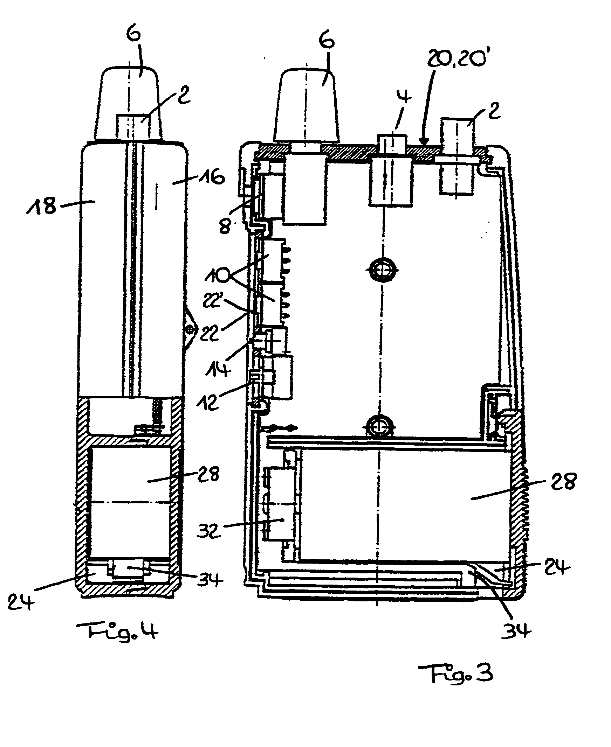

Das in den Fig. 3 und 4 dargestellte Funkgerät weist eine zweite elektrische Schaltung (nicht dargestellt) auf, zu deren Spannungsversorgung eine Batterie des Typs "Knopfbatterie" erforderlich ist. Das Batteriefach 24 weist ein darin befestigtes Stützelement 34 auf, das die Knopfbatterie 28 in dem Batteriefach 24 einklemmt, und eine aus dem Batteriefach 24 herausnehmbare Knopfleiste 32, deren Kontaktknöpfe durch Kabel mit der elektrischen Schaltung (nicht dargestellt) des Funkgeräts verbunden sind.

Wenn für die zweite elektrische Schaltung eine gegenüber der Frontplatte 20 und/oder der Seitenplatte 22 veränderte Frontplatte 20' und/oder Seitenplatte 22' erforderlich ist, kann bei der Fertigung des Funkgeräts die veränderte Frontplatte 20' bzw. Seitenplatte 22' anstelle der ursprünglichen Frontplatte 20 und/oder Seitenplatte 22 zwischen der unteren 16 und der oberen Gehäuseschale 18 in die Führung eingesetzt werden.

## Patentansprüche

1. Gehäuse für ein tragbares, elektrisches Gerät, nämlich Mikrofon-Taschensender und/oder Taschenempfänger und/oder Funkgerät zur Übertragung von Signalen, insbesondere von Audisignalen, mit einem Fach (24) zur Aufnahme von Batterien und/oder Akkumulatoren für eine Spannungsversorgung des Gerätes und von Anschlüssen zum Anschluß der Batterien an das Gerät, einer Aufnahme für Bedienorgane (4, 6, 8, 10, 12, 14) zum Bedienen des Gerätes und wenigstens einem Frontplattenbereich zur Aufnahme einer Frontplatte (20, 22) zum Ablesen von Einstellungen der Bedienorgane (4, 6, 8, 10, 12, 14),
**dadurch gekennzeichnet, daß** das Fach (24) für eine alternative Aufnahme von Standardbatterien (26, 28) wenigstens vom Typ "Mignon" (Figur 1, Figur 2) und vom Typ "Knopfbatterie" (Figur 3, Figur 4) vorgesehen ist und indem die Anschlüsse wahlweise zum Anschluß der Batterien (26, 28) der verschiedenen Typen verlegbar bzw. verlegt sind.

2. Gehäuse nach Anspruch 1,
**dadurch gekennzeichnet,**
**daß** der Frontplattenbereich für eine wahlweise Aufnahme verschiedener Frontplatten (20, 20', 22, 22') vorgesehen ist.

3. Gehäuse nach Anspruch 2,
**dadurch gekennzeichnet,**
**daß** der Frontplattenbereich für eine derartige Befestigung der Frontplatte (20, 20', 22, 22') an dem Gehäuse vorgesehen ist, daß diese mit dem Gehäuse eine elektrische und mechanische Einheit bildet.

4. Gehäuse nach Anspruch 2,
**dadurch gekennzeichnet,**
**daß** der Frontplattenbereich für eine lösbare Befestigung der Frontplatte (20, 20', 22, 22') ausgebildet ist.

5. Tragbares elektrisches Gerät mit einem Gehäuse nach einem der vorstehenden Ansprüche, wobei das Gerät ein Mikrofon-Taschensender, Taschenempfänger und/oder ein Funkgerät ist.

## Claims

1. Housing for a portable, electrical device, namely a microphone pocket transmitter and/or pocket receiver and/or radio device for transmitting signals, in particular audio signals, with a compartment (24) for holding batteries and/or accumulator batteries for a power supply to the device and connections for connecting the batteries to the device, a mount for operating elements (4, 6, 8, 10, 12, 14) for operating the device and at least one front plate section for mounting a front plate (20, 22) for reading settings of the operating elements (4, 6, 8, 10, 12, 14), **characterised in that** the compartment (24) is provided for the alternative mounting of standard batteries (26, 28) at least of the "miniature" type (Figure 1, Figure 2) and the "button battery" type (Figure 3, Figure 4), and **in that** the connections can be moved or are moved optionally for the connection of the batteries (26, 28) of different types.

2. Housing according to claim 1, **characterised in that** the front plate section is provided for the optional mounting of various front plates (20, 20', 22, 22').

3. Housing according to claim 2, **characterised in that** the front plate section is provided for such an attachment of the front plate (20, 20', 22, 22') on the housing, that the front plate forms an electrical and mechanical unit with the housing.

4. Housing according to claim 2, **characterised in that** the front plate section is designed for the releasable attachment of the front plate (20, 20', 22, 22').

5. Portable electrical device with a housing according to one of the preceding claims, whereby the device is a microphone pocket transmitter, pocket receiver and/or a radio device.

## Revendications

1. Boîtier pour un appareil électrique portatif, à savoir un émetteur de.poche pour microphone et/ou récepteur de poche et/ou appareil radio destinés à transmettre des signaux, en particulier des signaux audio, comprenant un compartiment (24) destiné à recévoir des batteries et/ou des accumulateurs pour une alimentation en courant de l'appareil et de connexions destinées à connecter les batteries à l'appareil, d'un logement pour éléments de commande (4, 6, 8, 10, 12, 14) destinés à commander l'appareil et d'au moins une zone de platine avant destinée à loger une platine avant (20, 22) pour lire les réglages des éléments de commande (4, 6, 8, 10, 12, 14),
**caractérisé en ce que** le compartiment (24) est prévu pour loger en alternance des piles standard (26, 28) au moins du type « mignon » (figure 1, figure 2) et du type « pile plate » (figure 3, figure 4) et les connexions pouvant être décalées ou étant décalées au choix par rapport à la connexion des piles (26, 28) des différents types.

2. Boîtier selon la revendication 1,
**caractérisé en ce que**
la zone de platine avant est prévue pour un logement au choix de différentes platines avant (20, 20', 22, 22').

3. Boîtier selon la revendication 2,
**caractérisé en ce que**
la zone de platiné avant pour une fixation de ce type de la platine avant (20, 20', 22, 22') est prévue sur le boîtier, **en ce que** ladite platine forme avec le boîtier une unité électrique et mécanique.

4. Boîtier selon la revendication 2,
**caractérisé en ce que**
la zone de platine avant est conçue pour une fixation amovible de la platine avant (20, 20', 22, 22').

5. Appareil électrique portatif comprenant un boîtier selon l'une quelconque des revendications précédentes, l'appareil étant un émetteur de poche pour microphone, un récepteur de poche et/ou un appareil radio.
